# EUROPEAN PATENT SPECIFICATION

(11) **EP 3 045 973 B1**
(45) Date of publication and mention of the grant of the patent: **11.04.2018**
(21) Application number: 14844507.5
(22) Date of filing: 24.07.2014
(51) Int. Cl.: G03F 1/66, H01L 21/673

(54) **CONTAINER FOR STORING PHOTOMASK BLANKS**
BEHÄLTER ZUM AUFBEWAHREN VON BLANKOFOTOMASKEN
RÉCIPIENT PERMETTANT DE CONSERVER DES ÉBAUCHES DE PHOTOMASQUES

(30) Priority: 11.09.2013 JP 2013188177
(43) Date of publication of application: 20.07.2016
(73) Proprietor: Shin-Etsu Polymer Co. Ltd., Tokyo 101-0041 (JP); Shin-Etsu Chemical Co., Ltd., Tokyo 100-0004 (JP)
(72) Inventor: SUZUKI, Tsutomu, Saitama-shi, Saitama 331-0811 (JP); OHORI, Shinichi, Itoigawa-shi, Niigata 941-0007 (JP); KOITABASHI, Ryuji, Joetsu-shi, Niigata 942-8601 (JP); NAKAGAWA, Hideo, Joestu-shi, Niigata 942-8601 (JP); TAKASAKA, Takuro, Joestu-shi, Niigata 942-8601 (JP); KINOSHITA, Takahiro, Joestu-shi, Niigata 942-8601 (JP); FUKUDA, Hiroshi, Joestu-shi, Niigata 942-8601 (JP)
(74) Representative: Schäfer, Matthias W.
(86) International application number: PCT/JP2014/003912
(87) International publication number: WO 2015/037176

(56) References cited:
- JP-A- H08 245 868
- JP-A- 2003 140 324
- JP-A- 2006 330 421
- JP-A- 2006 330 421
- JP-A- 2010 072 420
- US-A1- 2005 236 298
- US-A1- 2012 103 860

## Description

### CROSS-REFERENCE

Present application is based upon and claims the benefit of priority from the prior Japanese Application No. 2013-188177, filed on September 11, 2013.

### Technical Field

Present invention relates to a container for storing a photomask blank substrate applied to its surface a chemical-amplification-type photoresist to be used at a photolithography process in the process of manufacturing a semiconductor or a liquid crystal.

### Background Art

Design rules for design circuits including semiconductors are revised to advance schemes to make circuits finer year by year. With this, requirements for circuit patterns in terms of line width, shape and pitch with respect to photomasks for forming circuits have become increasingly strict. Photolithography methods have been used as methods for forming circuits. As a resist material for making circuits finer as described above, a chemical-amplification-type resist suitable for shorter wavelengths and higher resolution is frequently used. A photolithography method using a chemical-amplification-type resist is one for obtaining a desired circuit pattern by a process in which a catalytic substance in such a resist material is produced by application of light such as excimer laser light or application of an electron beam, and in which a heat treatment is performed in a subsequent step to cause the catalytic substance and a polymer to react with each other so that a portion irradiated with the light or electrons becomes soluble (positive type) or insoluble (negative type). Storage containers manufactured, for example, by injection molding using various plastics as a base member have heretofore been used as a storage container for storing and transporting a substrate having such a resist material applied thereto before application of light or electrons, because it is desirable to make the container light in weight for ease of transport or conveyance, and because the container can be mass-produced with lower cost.

However, there has been a risk of various volatile organic components generated form a plastic storage container made of a plastic material having some influence on the catalytic action and the action to make soluble or insoluble of a photoresist material applied on a photomask blank during storage or transport of the photomask blank, causing, in a resist pattern on the photomask blank formed by light or electron beam application, heat processing and development, a change in size, e.g., an increase or reduction in line width or a deformation or inclination of the pattern, and thereby causing failure to obtain the pattern in accordance with the design. In consideration of such a problem due to a plastic material, a storage container formed of a high-molecular material containing no nitrogen atoms or a storage container in which the total amount of nitrogen-containing compounds as outgas components is equal to or smaller than a predetermined amount has been proposed by paying attention to nitrogen compounds (see, for example, Patent Literature 1). US 2012/103860A1 discloses a substrate storage container for storing substrates, which consists of a main component and a cover molded using a material containing a synthetic resin (Patent literature 2).

### Citation List

### Patent Literature

Patent Literature 1
   Japanese Patent Laid-Open Publication No. 2003-140324.
Patent Literature 2
   US patent publication US 2012/103860 A1.

### Summary of Invention

### Technical Problem

However, since the above-described storage container is limited to a high-molecular material (plastic material) obtained by a monomer containing no nitrogen atoms or a plastic material suitable for this use is selected, measurement of the total amount of nitrogen-containing compounds in outgas components is required, which is disadvantageous in terms of time/cost efficiency. There is, therefore, a demand for further simplifying selection of a plastic material suitable for this use and further reducing contaminations of a photomask blank and a storage container with electrostatic attachment of small particles generated, for example, by friction on the plastic storage container formed by using a selected material during storage or transport of the photomask blank with the storage container or an opening/closing operation on the storage container, or particles existing in the atmosphere.

The present invention has been achieved to solve the above-described problems, and an object of the present invention is to reduce a contamination of a photomask blank due to attachment of dust or particles which can be generated during storage, transport or a container operation while limiting the influence on a resist pattern so that the quality and yield of the photomask blank are improved.

### Solution to Problem

The inventors of the present invention earnestly have made studies to solve the above-described problems and have achieved the present invention by finding that faults caused, for example, in the line width and shape of a resist pattern formed by exposure, photosensing and development after storage of a photomask blank having a chemical-amplification-type resist applied thereto can be reduced by using, for a storage container for storing and transporting the photomask blank, a plastic material constituting the storage container from which only an amount of caprolactam equal to or smaller than a certain value is generated, and which has a surface resistance value of 1.0E + 13 Ω or less, that a high-resolution resist pattern can thereby be obtained, and that the photomask blank and the storage container can thereby protected from fine dust and particles which can be generated during storage and transport of the photomask blank, and from particles existing in the atmosphere.

That is, according to one aspect of the present invention, there is provided a photomask blank substrate storage container for housing, transporting or storing a photomask blank substrate, wherein at least one of its component parts is formed of a thermoplastic resin having an amount of caprolactam of 0.01 ppm or less per resin weight on an n-decane basis in outgas, as measured by a dynamic head space method under the condition of being held at 40°C for 60 minutes, and the surface resistance value of the component part formed of the thermoplastic resin material is 1.0E + 13 Ω or less.

In the photomask blank substrate storage container, according to another aspect of the present invention, a carbon filler is added to the thermoplastic resin.

In the photomask blank substrate storage container, according to another aspect of the present invention, the thermoplastic resin is a durable antistatic resin.

According to a further aspect of the present invention, the photomask blank substrate storage container includes an upper lid forming a space for storing the photomask blank substrate and a lower box engaged with the upper lid, at least the upper lid and the lower box being formed of the above-described thermoplastic resin material.

### Advantageous Effects of Invention

According to the present invention, a contamination of a photomask blank due to attachment of dust or particles which can be generated during storage or transport of the photomask blank substrate or during a container operation can be reduced with improved reliability, while the influence on a resist pattern of volatile organic components generated from the container is limited, thus achieving improvements in quality and yield of the photomask blank.

### Brief Description of Drawings

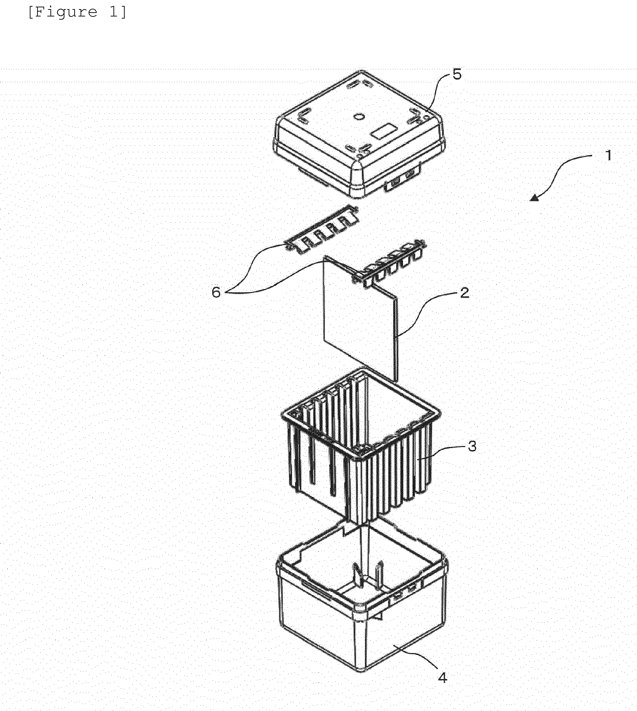

[Figure 1] Figure 1 shows an exploded perspective view of a photomask blank substrate storage container according to an embodiment of the present invention.

### Description of Embodiment

An embodiment of a photomask blank substrate storage container according to the present invention will be described below. The present invention, however, is not limited to the embodiment described below.

Figure 1 shows an exploded perspective view of a photomask blank substrate storage container according to an embodiment of the present invention.

A photomask blank substrate storage container 1 according to this embodiment has, as its main component parts, as shown in Figure 1, a cassette 3 capable of storing photomask blank substrates 2 by setting the photomask blank substrates 2 in state of standing vertically at regular intervals in a row, a lower box 4 in which the cassette 3 is housed, an upper lid 5 engaged with the lower box 4 from above, and pressing members 6 for pressing the photomask blank substrates 2 from above.

The lower box 4 is formed into the shape of a box open at its top and closed at its bottom. Rim portions are formed at the peripheral end of the upper opening. Pairs of engagement recesses are formed in a pair of rim portions in peripheral portions opposed to each other. The cassette 3 has a pair of end walls and another pair of walls, i.e., a pair of side walls connecting the pair of end walls. Housing grooves in which the photomask blank substrates 2 are housed are formed at certain intervals in the inner surfaces of the side walls to be opposed one to another. The upper lid 5 is formed into the shape of a box having a downward opening to cover and close the opening of the lower box 4. The upper lid 5 has rim portions formed in its opening portion. On each of a pair of the rim portions opposed to each other, a pair of engagement claws are formed to extend downward. The engagement claws respectively engage with the engagement recesses of the lower box 4 to fix the lower box 4 and the upper lid 5 to each other.

On an inner surface of the upper lid 5, the pressing members 6, which are members for pressing the photomask blank substrates 2 by individually contacting the photomask blank substrates 2, and which have holding grooves, are mounted to face downward. In this embodiment, at least lower box 4 and the upper lid 5 in the components of the above-described photomask blank substrate storage container 1 are formed of a thermoplastic resin having an amount of caprolactam of 0.01 ppm or less, more preferably smaller than 0.01 ppm per resin weight on an n-decane basis, as measured by a dynamic head space method under the condition of being held at 40°C for 60 minutes.

The lower box 4 and the upper lid 5 are formed of an antistatic material or a conductive material such that the surface resistance value is 1.0E + 13 Ω or less in order to reduce the attachment of particles. In the present invention, at least one of the cassette 3 and the pressing member 6 is formed of a thermoplastic resin having an amount of caprolactam of 0.01 ppm or less, more preferably smaller than 0.01 ppm per resin weight on an n-decane basis, as measured by the dynamic head space method under the condition of being held at 40°C for 60 minutes, as in the above-described case. The scheme of what caprolactam gives to the characteristics of a pattern is not clear. However, an amide bond in free caprolactam in outgas detected by the dynamic head space method under the condition of being held at 40°C for 60 minutes is thought to migrate to a chemical-amplification-type resist during storage and transport of photomask blank substrates to have some bad influence on the catalytic action at the time of exposure, photosensing or development.

Further, preferably, the thermoplastic resin is a durable antistatic resin. "Durable antistatic resin" refers herein to a resin obtained by dispersing not a filler such as carbon but a hydrophilic polymer in a base resin to have a durable antistatic function. The durable antistatic resin has the advantage of having a low-dust-generation characteristic in comparison with a resin obtained by dispersing a filler such as carbon in a base resin. As the base resin used for the durable antistatic resin, an ABS resin, an acrylic resin or a polypropylene resin may preferably be used. The hydrophilic polymer is, for example, a high-molecular solid electrolyte, particularly a polymer having a polyethylene glycol component. More specifically, examples of the hydrophilic polymer are polyethylene glycol methacrylate copolymer, poly(ethylene oxide-propylene oxide) copolymer, polyethylene glycol-based polyesteramide, and poly(epichlorohydrin-ethylene oxide) copolymer.

A filler such as carbon may be added to the thermoplastic resin. When a filler such as carbon is added to the thermoplastic resin, the surface resistance value can be reduced to 1.0E + 10 Ω or less in contrast to the case of using the durable antistatic resin. It is difficult to reduce the surface resistance value to 1.0E + 10 Ω or less when the durable antistatic resin is used. The attachment of particles by static electricity or the like to the storage container and the photomask blanks can thereby be reduced. Examples of the thermoplastic resin are polypropylene, polycarbonate, polybutylene terephthalate, an acrylic resin and an ABS resin. As a carbon filler, carbon black, acetylene black, carbon fibers or carbon nanotubes, for example, can be used.

The photomask blank substrate storage container according to the embodiment of the invention is not limited to containers such as the above-described one for storing a plurality of photomask blank substrates. The photomask blank substrate storage container may alternatively be a sheet container for individually storing a photomask blank sheet. Also, the photomask blank substrate storage container may be an enclosed-type container capable of isolation from outside air or a container allowing communication with outside air through a chemical filter.

### Examples

Examples of the present invention will be described along with comparative examples. The present invention is not limited to examples described below.

Examples 1 to 6 will be described below and Table 1 shows evaluation results.

### (Example 1)

Two pieces of molding: an upper lid and a low box capable of housing a cassette in which a plurality of photomask blank substrates of a 152 mm square such as shown in Figure 1 can stand together were manufactured by injection molding using an acrylic-based durable antistatic resin A on the market. The surface resistance value at a flat portion of the ceiling surface of the manufactured upper lid was measured by using a surface high-resistance measuring device (a product from Shishido Electrostatic,. Ltd.). The measured surface resistance value was 1/0E + 11 Ω. 0.1 gram of the material was cut off from a portion of the upper lid, put in a sample cell after being precisely measured, and subjected to heating desorption at 40°C for 60 minutes in a high-purity helium atmosphere. Gas components generated were analyzed with a gas chromatography mass analyzer (GC-MS). A peak area value corresponding to the caprolactam component was converted with a measuring line prepared with n-Decane and was divided by the specimen weight to be obtained in (ppm). The result of measurement of caprolactam was smaller than 0.01 ppm. The caprolactam component was identified by collating the corresponding MS spectrum with a database (NIST).

Also, a cassette in which a plurality of photomask blank substrates of a 152 mm square such as shown in Figure 1 can stand together and pressing members which can be fitted inside the upper lid and with which substrates housed in the cassette are fixed from above when the upper lid is fitted to the lower box were manufactured by injection molding using a commercially available polyethylene terephthalate resin. Amounts of caprolactam obtained from the manufactured cassette and the pressing members under the conditions: 40°C and 60 minutes after sampling in the same way as described above were smaller than 0.01 ppm.

On the other hand, one photomask blank substrate to which a chemical-amplification-type photoresist was applied was housed in a central slot in the above-described cassette, followed by mounting in the lower box and putting of the upper lid on the lower box. The photomask blank substrate was stored in this state at ordinary temperature for three months. Next, EB drawing, baking and development processing were successively performed on the photomask blank substrate after storage to form a line/space (L/S) resist pattern with a line width of 400 nm. A deviation of the space width from a predetermined size was defined as a CD value and the line width was measured. As a result of this, no substantial change in CD value was recognized (passing criterion: ≤±5 nm). Also, no substantial change in shape was recognized in SEM observation of a cross section. Further, three photomask blanks having the chemical-amplification-type photoresist already applied thereto and having undergone the process of measuring the number of defects with a photomask blank defect inspection device (MAGICS: M2351, a product from Lasertec Corporation) before an opening/closing test were housed in this storage container, an operator repeated opening/closing of the upper lid ten times, and the number of defects was again measured (passing criterion: <1). This process was performed a certain number of times and the differences between the number of defects before and after the lid opening/closing operations were calculated as increases in number of defects. The increase in number of defects per upper lid opening/closing and per photomask blank was 0.25 and substantial increase in number of defects was not almost recognized.

### (Example 2)

A storage container was manufactured under the same conditions as those in Example 1 except that a commercially available acrylic-based durable antistatic resin B was used as the material of the upper lid and the lower box. The surface resistance value of the manufactured upper lid was 1.5E + 12 Ω and the amount of caprolactam in outgas was smaller than 0.01 ppm. Also, substantial change in CD value was not almost recognized with respect to the line width of a pattern obtained by drawing, baking and development on a photomask blank substrate stored in the storage container for three months in the same way as in Example 1, and substantial change in sectional shape of the pattern was not almost recognized. Further, in the results of the opening/closing test made on the storage container in the same way as in Example 1, the increase in number of defects of the photomask blank substrate per upper lid opening/closing and per photomask blank was 0.67 and substantial increase in number of defects was not almost recognized.

### (Example 3)

A storage container was manufactured under the same conditions as those in Example 1 except that a commercially available ABS-based durable antistatic resin C was used as the material of the upper lid and the lower box. The surface resistance value of the manufactured upper lid was 7.0E + 11 Ω and the amount of caprolactam in outgas was 0.01 ppm. Also, substantial change in CD value was not almost recognized with respect to the line width of a pattern obtained by drawing, baking and development on a photomask blank substrate stored in the storage container for three months in the same way as in Example 1, and substantial change in sectional shape of the pattern was not almost recognized. Further, in the results of the opening/closing test made on the storage container in the same way as in Example 1, the increase in number of defects of the photomask blank substrate per upper lid opening/closing and per photomask blank was 0.17 and substantial increase in number of defects was not almost recognized.

### (Example 4)

A storage container was manufactured under the same conditions as those in Example 1 except that a commercially available polypropylene-based carbon black-blended antistatic resin D was used as the material of the upper lid and the lower box. The surface resistance value of the manufactured upper lid was 3.6E + 03 Ω and the amount of caprolactam in outgas was smaller than 0.01 ppm. Also, substantial change in CD value was not almost recognized with respect to the line width of a pattern obtained by drawing, baking and development on a photomask blank substrate stored in the storage container for three months in the same way as in Example 1, and substantial change in sectional shape of the pattern was not almost recognized. Further, in the results of the opening/closing test made on the storage container in the same way as in Example 1, the increase in number of defects of the photomask blank substrate per upper lid opening/closing and per photomask blank was 0.11 and substantial increase in number of defects was not almost recognized.

### (Example 5)

A storage container was manufactured under the same conditions as those in Example 1 except that a commercially available polycarbonate-based carbon black-blended antistatic resin E was used as the material of the upper lid and the lower box. The surface resistance value of the manufactured upper lid was 3.6E + 3 Ω and the amount of caprolactam in outgas was smaller than 0.01 ppm. Also, substantial change in CD value was not almost recognized with respect to the line width of a pattern obtained by drawing, baking and development on a photomask blank substrate stored in the storage container for three months in the same way as in Example 1, and substantial change in sectional shape of the pattern was not almost recognized. Further, in the results of the opening/closing test made on the storage container in the same way as in Example 1, the increase in number of defects of the photomask blank substrate per upper lid opening/closing and per photomask blank was 0.14 and no substantial increase in number of defects was recognized.

### (Example 6)

A storage container was manufactured under the same conditions as those in Example 1 except that a commercially available polybutylene terephthalate-based carbon black-blended antistatic resin J was used as the material of the upper lid and the lower box. The surface resistance value of the manufactured upper lid was 2.0E + 06 Ω and the amount of caprolactam in outgas was smaller than 0.01 ppm. Also, substantial change in CD value was not almost recognized with respect to the line width of a pattern obtained by drawing, baking and development on a photomask blank substrate stored in the storage container for three months in the same way as in Example 1, and substantial change in sectional shape of the pattern was not almost recognized. Further, in the results of the opening/closing test made on the storage container in the same way as in Example 1, the increase in number of defects of the photomask blank substrate per upper lid opening/closing and per photomask blank was 0.15 and substantial increase in number of defects was not almost recognized.

### Comparative Examples 1 to 4 will be described below. Table 2 shows evaluation results.

### (Comparative Example 1)

A storage container was manufactured under the same conditions as those in Example 1 except that a commercially available ABS-based durable antistatic resin F was used as the material of the upper lid and the lower box. The surface resistance value of the manufactured upper lid was 3.0E + 11 Ω and the amount of caprolactam in outgas was as large as 0.57 ppm. The CD value with respect to the line width of a pattern obtained by drawing, baking and development on a photomask blank substrate stored in the storage container for three months in the same way as in Example 1 was changed about 10 nm in the reducing direction relative to the setting. In the results of the opening/closing test made on the storage container in the same way as in Example 1, however, the increase in number of defects of the photomask blank substrate per upper lid opening/closing and per photomask blank was 0.20 and substantial increase in number of defects was not almost recognized.

### (Comparative Example 2)

A storage container was manufactured under the same conditions as those in Example 1 except that a commercially available polypropylene-based durable antistatic resin G was used as the material of the upper lid and the lower box. The surface resistance value of the manufactured upper lid was 1.0E + 10 Ω and the amount of caprolactam in outgas was 2.00 ppm. The CD value with respect to the line width of a pattern obtained by drawing, baking and development on a photomask blank substrate stored in the storage container for three months in the same way as in Example 1 was extremely largely changed about 40 nm in the reducing direction relative to the setting. In the results of the opening/closing test made on the storage container in the same way as in Example 1, however, the increase in number of defects of the photomask blank substrate per upper lid opening/closing and per photomask blank was 0.44 and substantial increase in number of defects was not almost recognized.

### (Comparative Example 3)

A storage container was manufactured under the same conditions as those in Example 1 except that a commercially available acrylic resin H was used as the material of the upper lid and the lower box. The surface resistance value of the manufactured upper lid was larger than 1.0E + 16 Ω and no caprolactam was detected from outgas. Substantial change in CD value was not almost recognized with respect to the line width of a pattern obtained by drawing, baking and development on a photomask blank substrate stored in the storage container for three months in the same way as in Example 1, and substantial change in sectional shape of the pattern was not almost recognized. In the results of the opening/closing test made on the storage container in the same way as in Example 1, however, the increase in number of defects of the photomask blank substrate per upper lid opening/closing and per photomask blank was as large as 2.13.

### (Comparative Example 4)

A storage container was manufactured under the same conditions as those in Example 1 except that a commercially available ABS-based durable antistatic resin I was used as the material of the upper lid and the lower box. The surface resistance value of the manufactured upper lid was 5.0E + 11 Ω and the amount of caprolactam in outgas was 0.92 ppm. The CD value with respect to the line width of a pattern obtained by drawing, baking and development on a photomask blank substrate stored in the storage container for three months in the same way as in Example 1 was changed about 10 nm in the reducing direction relative to the setting. In the results of the opening/closing test made on the storage container in the same way as in Example 1, however, the increase in number of defects of the photomask blank substrate per upper lid opening/closing and per photomask blank was 0.56 and substantial increase in number of defects was not almost recognized.

**[Table 1]**

| | | Example 1 | Example 2 | Example 3 | Example 4 | Example 5 | Example 6 |
|---|---|---|---|---|---|---|---|
| Base resin | | Acrylic | Acrylic | ABS-based (*1) | PP-based (CB)(*2) | PC-based (CB)(*3) | PBT-based (CB)(*4) |
| Type | | Durable antistatic res in | Durable antistatic res in | Durable antistatic res in | Carbon filler-based antistatic res in | Carbon filler-based antistatic res in | Carbon filler-based antistatic res in |
| Sample | | A | B | C | D | E | J |
| Amount of caprolactam (at 40°C for 60 minutes) | ppm | <0.01 | <0.01 | <0.01 | <0.01 | <0.01 | <0.01 |
| Pattern characteristics | Change in line width (CD value) (nm) | 2.3 | 1.0 | -1.9 | -2.3 | -4.0 | -3.0 |
| | Shape | 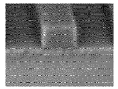 | 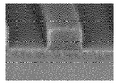 | 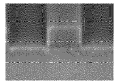 | 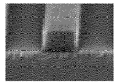 | 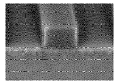 | 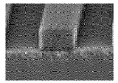 |
| Surface resistance value | Ω | 1.0E+11 | 1.5E+12 | 7.0E+11 | 3.6E+03 | 3.6E+03 | 2.0E+06 |
| Number of defects/sheet | Number | 0.25 | 0.67 | 0.17 | 0.11 | 0.14 | 0.15 |

| | | | | | | | |
|---|---|---|---|---|---|---|---|
| *1 ABS-based (acrylonitrile-butadiene-styrene-based) *2 PP-based (CB): polypropylene-based (carbon black-based) *3 PC-based (CB): palycarbanate-based (carbon black-based) *4 PBT-based (CB): polybutylene terephthalate-based (carbon black-based) | | | | | | | |

**[Table 2]**

| | | Comparative Example 1 | Comparative Example 2 | Comparative Example 3 | Comparative Example 4 |
|---|---|---|---|---|---|
| Base resin | | ABS-based | PP-based | Acrylic-based | ABS-based |
| Type | | Durable antistatic resin | Durable antistatic resin | General (non-antistatic) | Durable antistatic resin |
| Sample | | F | G | H | I |
| Amount of caprolactam(at 40°C for 60 minutes) | ppm | 0.57 | 200 | <0.01 | 0.92 |
| Pattern characteristics | Change in line width (CD value) (nm) | -9.9 | -39.2 | 3.5 | -10.0 |
| | Shape | 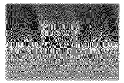 | No section photograph | 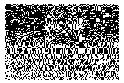 | 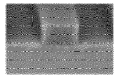 |
| Surface resistance value | Ω | 3.0E+11 | 10E+10 | 1.0E+16< | 6.0E+11 |
| Number of defects/sheet | Number | 0.20 | 0.44 | 2.13 | 0.56 |

### Industrial Applicability

The present invention can be used, for example, as a container for housing, transporting or storing photomask blank substrates.

### Reference Signs List

- 1: Photomask blank substrate storage container
- 2: Photomask blank substrate
- 4: Lower box
- 5: Upper lid

## Claims

1. A photomask blank substrate storage container (1) for housing, transporting or storing a photomask blank substrate (2) having a chemical-amplification-type photoresist applied to its surface, the container being composed of a material adapted to reduce contaminations to photomask blank substrates having a chemical-amplification-type photoresist applied to their surface, wherein at least one of its component parts is formed of a thermoplastic resin having an amount of caprolactam of 0.01 ppm or less per resin weight on an n-decane basis in outgas, as measured by a dynamic head space method under the condition of being held at 40°C for 60 minutes, and the surface resistance value of the component part formed of the thermoplastic resin material is 1.0E + 13 Ω or less.

2. The photomask blank substrate storage container (1) of claim 1, wherein a carbon filler is added to the thermoplastic resin.

3. The photomask blank substrate storage container (1) of claim 1, wherein the thermoplastic resin is a durable antistatic resin.

4. The photomask blank substrate storage container (1) of any one of claims 1 to 3, comprising an upper lid (5) forming a space for storing the photomask blank substrate (2) and a lower box (4) engaged with the upper lid (5), wherein at least the upper lid (5) and the lower box (4) are formed of the thermoplastic resin material.

## Patentansprüche

1. Blankofotomaskensubstrat-Aufbewahrungsbehälter (1) zum Aufnehmen, Transportieren oder Aufbewahren eines Blankofotomaskensubstrats (2), welches einen auf seiner Oberfläche aufgebrachten chemisch verstärkten Fotolack aufweist,
wobei der Behälter von einem Material gebildet ist, welches dafür angepasst ist, um Verunreinigungen an Blankofotomaskensubstraten, welche einen auf ihrer Oberfläche aufgebrachten chemisch verstärkten Fotolack aufweisen, zu verringern,
wobei mindestens eine seiner Komponenten aus einem thermoplastischen Harz gebildet ist, welches einen Gehalt an Caprolactam von 0,01 ppm oder weniger pro Gewicht an Harz auf einer Basis von n-Dekan bei Ausgasung aufweist, gemessen nach einem dynamischen Dampfraum-Verfahren unter der Bedingung, für 60 Minuten bei 40°C gehalten zu werden, und der Oberflächenwiderstandswert der aus dem thermoplastischen Harzmaterial gebildeten Komponente 1,0E + 13 Ω oder weniger beträgt.

2. Blankofotomaskensubstrat-Aufbewahrungsbehälter (1) nach Anspruch 1, wobei dem thermoplastischen Harz ein Kohlenstoff-Füllmaterial zugegeben ist.

3. Blankofotomaskensubstrat-Aufbewahrungsbehälter (1) nach Anspruch 1, wobei das thermoplastische Harz ein haltbares, antistatisches Harz ist.

4. Blankofotomaskensubstrat-Aufbewahrungsbehälter (1) nach einem der Ansprüche 1 bis 3, aufweisend einen oberen Deckel (5), welcher einen Raum zum Aufbewahren des Blankofotomaskensubstrats (2) bildet, und einen unteren Kasten (4), welcher mit dem oberen Deckel in Eingriff ist, wobei mindestens der obere Deckel (5) und der untere Kasten (4) aus dem thermoplastischen Harzmaterial gebildet sind.

## Revendications

1. Un conteneur permettant de conserver un substrat d'ébauche de photomasque (1) pour le rangement, le transport et la conservation d'un substrat d'ébauche de photomasque (2) présentant une photorésistance de type amplification chimique appliquée à sa surface,
le conteneur étant composé d'un matériau adapté afin de réduire les contaminations des substrats d'ébauche de photomasque présentant une photorésistance de type amplification chimique appliquée à leurs surface,
étant précisé qu'au moins une de ses parties composantes est formée par une résine thermoplastique présentant une concentration en caprolactame de 0,01 ppm ou moins par rapport au poids de la résine ou une base de n-décane au dégazage, comme mesuré par la méthode de l'espace de tête dans des conditions selon lesquelles la température est de 40° pendant 60 minutes, et la valeur de résistance de la surface de la partie composante formée par le matériau de résine thermoplastique est de 1,0E + 13 Ω ou moins.

2. Le conteneur permettant de conserver un substrat d'ébauche de photomasque (1) selon la Revendication 1 étant précisé qu'une charge de carbone est ajoutée à la résine thermoplastique.

3. Le conteneur permettant de conserver un substrat d'ébauche de photomasque (1) selon la Revendication 1 étant précisé que la résine thermoplastique est une résine antistatique durable.

4. Le conteneur permettant de conserver un substrat d'ébauche de photomasque (1) selon l'une quelconque des Revendications 1 à 3, comprenant un couvercle supérieur (5) formant un espace pour la conservation du substrat d'ébauche de photomasque (2) et une boîte inférieure (4) engagée avec le couvercle supérieur (5), étant précisé qu'au moins le couvercle supérieur (5) et la boîte inférieure (4) se composent de matériau de résine thermoplastique.
